# EUROPEAN PATENT SPECIFICATION

(11) **EP 1 896 874 B1**
(45) Date of publication and mention of the grant of the patent: **27.08.2014**
(21) Application number: 06785226.9
(22) Date of filing: 20.06.2006
(51) Int. Cl.: G01R 27/08, G01V 3/24

(54) **HIGH FREQUENCY OR MULTIFREQUENCY RESISTIVITY TOOL**
HOCHFREQUENTES ODER MULTIFREQUENTES WIDERSTANDSMESSGERÄT
OUTIL A RESISTIVITE MULTIFREQUENCE OU HAUTE FREQUENCE

(30) Priority: 20.06.2005 US 692301 P
(43) Date of publication of application: 12.03.2008
(73) Proprietor: Halliburton Energy Services, Inc., Houston, TX 77072 (US); Morys, Marian, Downingtown, PA 19335 (US); Knizhnik, Sergei, Exton, PA 19341 (US); Gallagher, William Francis, III, Phoenixville, PA 19460 (US)
(72) Inventor: MORYS, Marian, Downingtown, PA 19335 (US); KNIZHNIK, Sergei, Exton, PA 19341 (US); GALLAGHER, William, Francis, III, Phoenixville, PA 19460 (US)
(74) Representative: Curtis, Philip Anthony
(86) International application number: PCT/US2006/024056
(87) International publication number: WO 2007/002132

(56) References cited:
- GB-A- 2 406 650
- US-A- 5 235 285
- US-A1- 2002 153 897
- US-B1- 6 373 254
- US-B2- 6 809 521

## Description

### II. Background

### A. Field of the Invention

This invention relates to the field of well logging. More particularly, the invention relates to a method and apparatus for improved injection of current into a formation and reduction of the effect of standoff distance from the formation during resistivity measurements.

### B. Description of the Related Art

Resistivity logging, which measures the electrical resistivity of earth formations surrounding a borehole, is a commonly used technique for formation evaluation. In general, porous formations having high resistivity are filled with hydrocarbons, while porous formations having low resistivity are water saturated. One technique used to measure formation resistivity is electrode logging. This resistivity measurement technique uses various arrangements of electrodes on a logging device to generate and measure electrical currents and/or potentials from which one determines formation resistivity.

Various formation resistivity logging tools and techniques exist to perform resistivity logging. One of such tools that may be used for resistivity logging is a laterolog tool. A laterolog tool has lateral electrodes and is described in U.S. Patent Number 3,305,771 to Arps; U.S. Patent Number 5,235,285 to Clark et al.; and S. Bonner et al., "A New Generation of Electrode Resistivity Measurements for Formation Evaluation While Drilling", SPWLA, June 1994. The electrodes are mounted using insulation on the electrically conductive body of the LWD tool. The electrodes may be mounted on the tool collar, stabilizer blades, or some other part of the tool body.

During formation resistivity measurements, a voltage difference is created between two sections of the electrically conductive drill collar. The tool may contain a device to generate a voltage and a device to measure the resulting current through the one or more electrodes. The electrode to measure current may be a ring electrode or button electrode. The ring electrode comprises a metal band around the tool while the button electrode comprises a metal disc mounted on the tool collar. Both ring and button electrodes are electrically isolated from the tool. The collar surrounding the ring or button electrode acts as a guard electrode to focus more of the electrode current into/out of the formation.

During a resistivity logging operation, an impedance layer may develop on the tool collar and/or the surface of an electrode and may affect the flow of current between the electrode and borehole fluid or mud. The value of contact impedance depends on a number of factors (electrode potential, temperature, electrode material and roughness, exposure time, pH, fluid salinity, and frequency) and is highly variable.

The surface impedance layer can cause the current to be different from what it would have been in a perfect tool without surface impedance. When current flows into or out of an electrode or into or out of the collar through a surface impedance layer, a voltage drop is produced and the potential immediately outside the metal becomes different from the potential inside the metal. A particularly damaging effect occurs whenever two nearby electrodes (i.e. an electrode and the tool collar) have different surface impedances. When this situation occurs, the potential immediately outside the electrode will be different from that immediately outside of the tool collar. This difference causes a current to flow between the electrode and the tool collar, which affects the current flowing through the formation. The smaller the mud resistance, the larger the effect of the surface impedance.

Another bad effect of the surface impedance layer is to reduce the effectiveness of the tool collar as a guard electrode, reducing clarity of the contrast measurement of thin formation layers of different conductivity, effectively reducing the tool's vertical and azimuthal resolution.

One type of laterolog tool that may minimize the effect of surface impedance employs separate voltage monitoring electrodes to sense the voltage of the mud near the surface of the tool. The monitor electrodes emit essentially no current and so are unaffected by surface impedance. Focusing is achieved by means of a feedback loop that adjusts the bucking or survey current to maintain monitoring electrodes at the same voltage.

The diameter of a typical button electrode in a resistivity logging tool is about one inch but, with two surrounding monitor electrodes, the diameter of the electrode assembly may well exceed two inches. Since the electrode assembly is typically placed on the tool collar, stabilizer blades, or some other part of the tool body, the electrode assembly becomes extremely vulnerable in a drilling environment. Accordingly, using separate voltage monitoring electrodes in the resistivity logging tool to minimize the effect of surface impedance on resistivity measurements makes the tool more complex and reduces the reliability/survivability of the tool in an LWD environment.

### III. Summary

In one respect, disclosed is a method for resistivity logging, the method comprising: generating a current, the current oscillating at one or more frequencies, at least one of the frequencies being above a critical frequency; directing the current through a surrounding material; and detecting the current and, in response thereto, determining a resistivity of the surrounding material at the one or more frequencies.

In another respect, disclosed is an apparatus for resistivity logging, the apparatus comprising: a current generating device, the device being operable to generate a current oscillating at one or more frequencies, at least one of the frequencies being above a critical frequency; one or more electrodes coupled to the generating device, the electrodes being adapted to direct current through a surrounding material; and an analysis device coupled to the one or more electrodes, the analysis device being operable to detect the current and determine a resistivity of the surrounding material.

Numerous additional embodiments are also possible.

### IV. Brief Description of the Drawings

Other objects and advantages of the invention may become apparent upon reading the detailed description and upon reference to the accompanying drawings.
Figure 1 is a diagram showing an electrode mounted on the surface of a drilling tool in accordance with one embodiment.
Figure 2 is a diagram showing a side view of a drilling tool having an electrode mounted on the surface of the tool and circuitry connected to the electrode in accordance with one embodiment.
Figure 3A is a diagram showing a test setup for measuring surface impedance test setup in accordance with one embodiment
Figure 3B is a diagram showing resistance-capacitance (RC) model of the test setup shown in Figure 3A in accordance with one embodiment
Figure 4 is a pair of graphs showing the measured magnitude and phase of the impedance from the test setup and RC model shown in Figures 3 in accordance with one embodiment
Figure 5 is a graph showing how various parameters in the test setup and RC model shown in Figure 3 change over time at a frequency of 1 KHz in accordance with one embodiment.
Figure 6 is a diagram showing another test setup for determining azimuthal button response and standoff response versus frequency in accordance with one embodiment.
Figure 7 is a graph of resistivity versus azimuthal angle with data collected using the test setup shown Figure 6 over a number of frequencies with ¼" standoff in a 0.1 ohm-meter fluid in accordance with one embodiment.
Figure 8 is a graph of conductivity change versus standoff with data collected using the test setup of Figure 6 over a number of frequencies in accordance with one embodiment.
Figure 9 is a flow diagram describing a method for detecting current through a material to measure the resistivity of the material.

While the invention is subject to various modifications and alternative forms, specific embodiments thereof are shown by way of example in the drawings and the accompanying detailed description. It should be understood, however, that the drawings and detailed description are not intended to limit the invention to the particular embodiment. This disclosure is instead intended to cover all modifications, equivalents, and alternatives falling within the scope of the present invention as defined by the appended claims.

### V. Detailed Description

One or more embodiments of the invention are described below. It should be noted that these and any other embodiments are exemplary and are intended to be illustrative of the invention rather than limiting. While the invention is widely applicable to different types of systems, it is impossible to include all of the possible embodiments and contexts of the invention in this disclosure. Upon reading this disclosure, many alternative embodiments of the present invention will be apparent to persons of ordinary skill in the art.

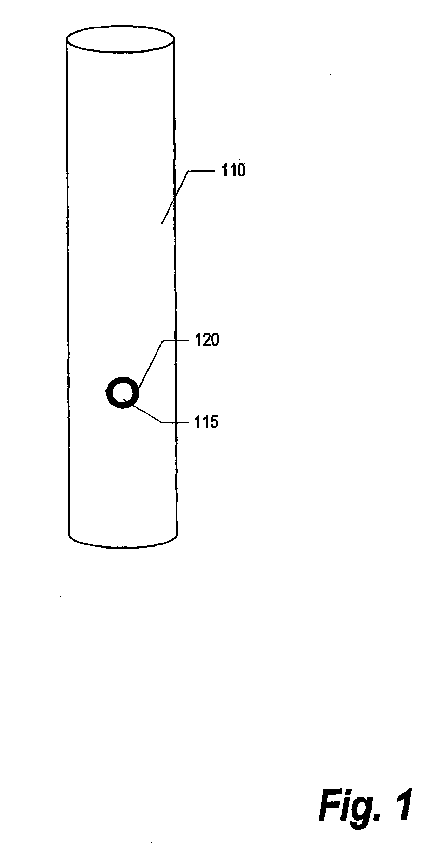

Figure 1 is a diagram showing an electrode mounted on the surface of a drilling tool in accordance with one embodiment. Electrode 115 is shown here mounted on the surface of drilling tool 110. The electrode is isolated from the body of the tool using insulator 120. Other shapes and arrangements of electrodes may also be possible. For example, the electrode may form a ring around the drilling tool instead of being circular. Or the electrode may form a ring around other electrodes. Furthermore, additional electrodes may be present on the tool's surface in the vertical, azimuthal direction or both.

Examples of such electrodes on a tool used for resistivity measurements are described in S. Bonner et al., "A New Generation of Electrode Resistivity Measurements for Formation Evaluation While Drilling". As the tool rotates and advances into the earth formation, formation resistivity may be determined by studying the current flowing through one or more such electrodes. The variation of the resistivity in different directions and positions may be used to determine the composition of the formation at those directions and positions.

Another resistivity imaging LWD tool and field test results using the tool are described in Ritter et al, "High Resolution Visualiztion of Near Wellbore Geology Using While-Drilling Electrical Images", SPWLA 2004, paper PP.

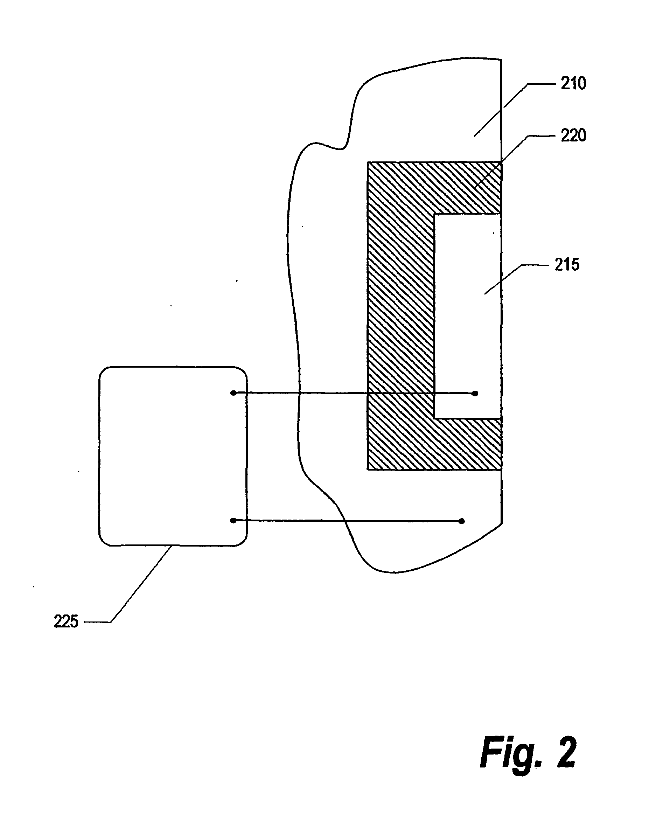

Figure 2 is a diagram showing a side view of a drilling tool having an electrode mounted on the surface of the tool and circuitry connected to the electrode in accordance with one embodiment Figure 2 shows how electrode 215 may be mounted onto a section of drilling tool 210. Insulator 220 may be used to electrically isolate conductive electrode 215 from the conductive body of drilling tool 210.

Circuitry 225 is operable to generate a voltage and consequently current that can flow from/to electrode 215 to/from the body of drilling tool 210. By doing so, the resistivity of the material surrounding electrode 215 and tool 210 may be measured and the material's composition may be estimated. Circuitry 225 may contain, among other components, operational amplifiers, resistors, transformers, and voltage generators configured to output DC and AC voltages at different frequencies, amplitudes, and phases. Other types of electrodes-as well as additional electrodes-having the same functionality as the electrode shown in Figure 2 may be used.

In one embodiment, circuitry 225 is operable to generate currents at high frequencies as well as multifrequency currents to overcome problems that may occur from increased impedance on the surface of the electrode. Such increase in impedance may occur over time, for example, due to the built up of residue on the surface of electrode 215 and drilling tool 210. United States Patent number 6,373,254 to Dion describes some of these problems. The increase in the surface impedance as well as the differences in surface impedance that may build up degrades the current focusing effect of the electrode and leads to artifacts and noise in the detected responses.

In one embodiment, electrode response accuracy may be improved by using alternating current at a number of different high frequencies for resistivity measurement. Due to the capacitive nature of the surface impedance, higher current frequencies can be affected less (experience reduced impedance) compared to lower frequencies. In addition, by taking measurements at multiple frequencies, the behavior of the surface impedance layer can be studied and its effects minimized.

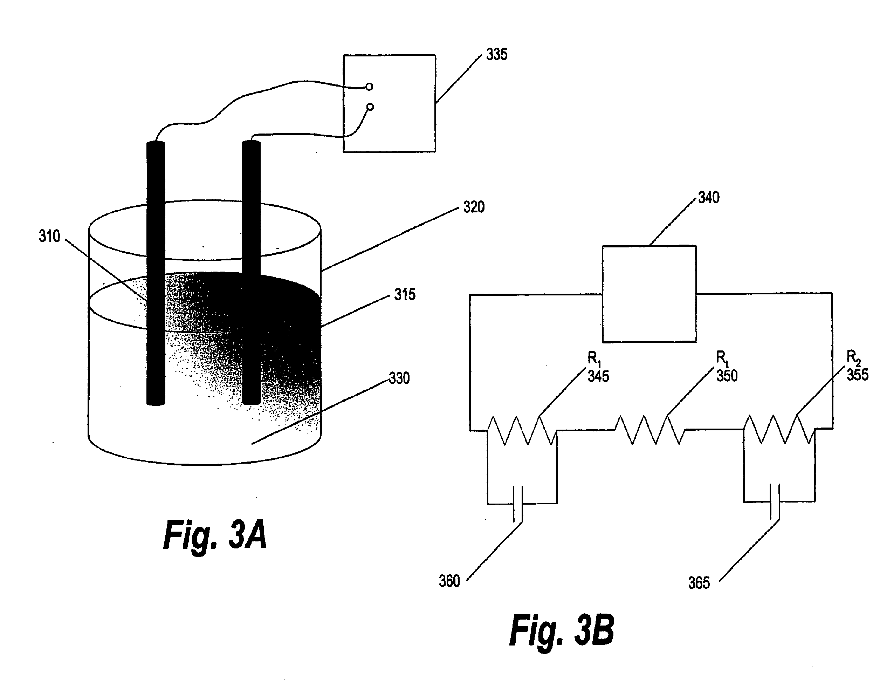

Figure 3A is a diagram showing a test setup for measuring surface impedance test setup in accordance with one embodiment When electrodes 310 and 315 (simulating the electrodes and/or body of the drilling tool) are submerged into conductive fluid 330 (simulating the mud in the environment) in container 320, an impedance layer is expected to develop on the surface of electrodes 310 and 315. Circuitry 355 is operable to provide voltage (and consequently current) at different frequencies, amplitudes, phases, etc.. In order to estimate the behavior of this impedance layer and to determine the capacitive characteristics of the surface impedance layer, controlled experiments were conducted.

In one embodiment, salt water having a resistivity of 0.1 ohm-meter is used as conductive fluid 330. In certain cases, the rods that are used as electrodes are cleaned with an abrasive pad to ensure that no surface impedance layer exists in the beginning of the experiment In one session, the magnitude and phase of the impedance of the system is measured over time of about two hours at different frequencies (in the range from 100Hz to 100 KHz). The data is then fit to the RC-model shown in Figure 3B using a least-squares optimization, for example.

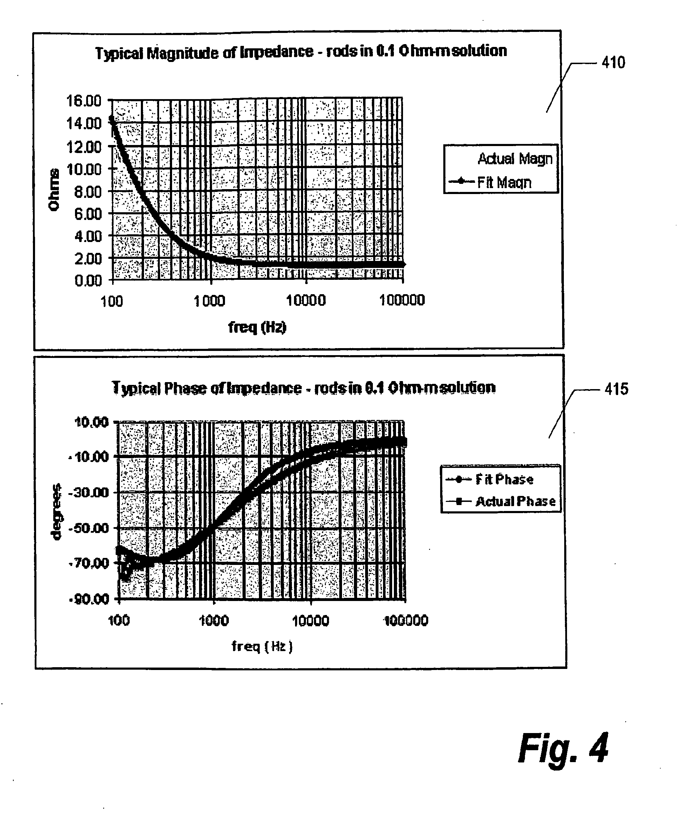

Figure 3B is a diagram showing resistance-capacitance (RC) model of the test setup shown in Figure 3A in accordance with one embodiment The RC-model of the measured impedance includes five elements: Rt represents the true impedance of the salt water measured between two electrodes; and R1, R2, C1 and C2 are resistances and capacitances associated with the impedance layer on the electrode surfaces respectively. The results of the measurements and the fit are shown in Figure 4.

Figure 4 is a pair of graphs showing the measured magnitude and phase of the impedance from the test setup and RC model shown in Figures 3 in accordance with one embodiment

As shown in graphs 410 and 415 of Figure 4, the impedance is significantly lower at high frequency than at low frequency. The phase of the impedance also approaches zero at high frequencies. This is most likely due to the capacitive nature of the surface impedance, which appears to substantially decreases at frequencies above 10 KHz. Thus, at higher frequencies, a more accurate estimation of Rt, the true impedance of the salt water measured between two electrodes, may be made without consideration of the surface impedance effect Rt, R1, R2, C1, and C2 in the RC model will vary over time from the start of the experiment, depending on the composition of the surrounding material used for electrodes, water salinity, electrode surface finish, and so on. Even with the different values for these parameters, however, the capacitive component of the surface impedance will be substantially negligible and, starting above a certain critical frequency as shown in Figure 4, and the estimation of Rt with a given accuracy may be performed without regard to the surface impedance effect

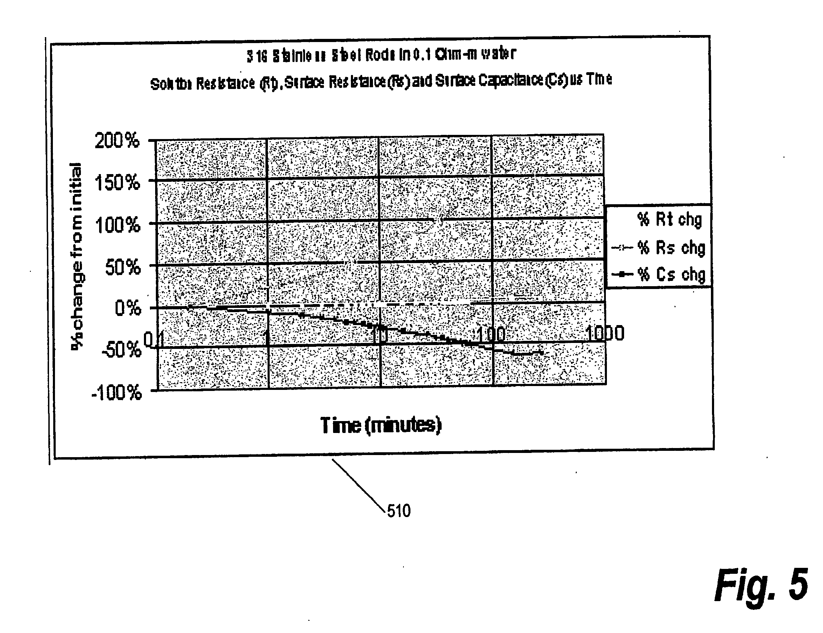

Figure 5 is a graph showing how various parameters in the test setup and RC model shown in Figure 3 change over time at a frequency of 1 KHz in accordance with one embodiment.

Graph 510 of Figure 5 shows how Rt, Rs, and Cs change at a frequency of 1 KHz over time. We assume that Rs=R1=R2 and Cs=C1=C2. As can be seen from the graph, Rt remains largely unchanged, as expected. Rs and Cs, on the other hand, begin to change after approximately 15 seconds from the beginning of the experiment (after the electrodes are cleaned with an abrasive pad and submerged in the fluid). The real component of the surface impedance, Rs (associated with electrode corrosion) increases with time, while the capacitance, Cs (associated with a double-layer electrode-fluid solution interface) decreases. The graph of Figure 5 suggests that, over time, the surface impedance will grow over at least the first 100 minutes. The abrasive nature of the LWD environment causes the electrode corrosion to build up and be wiped clean resulting in the electrode surface impedance varying over time.

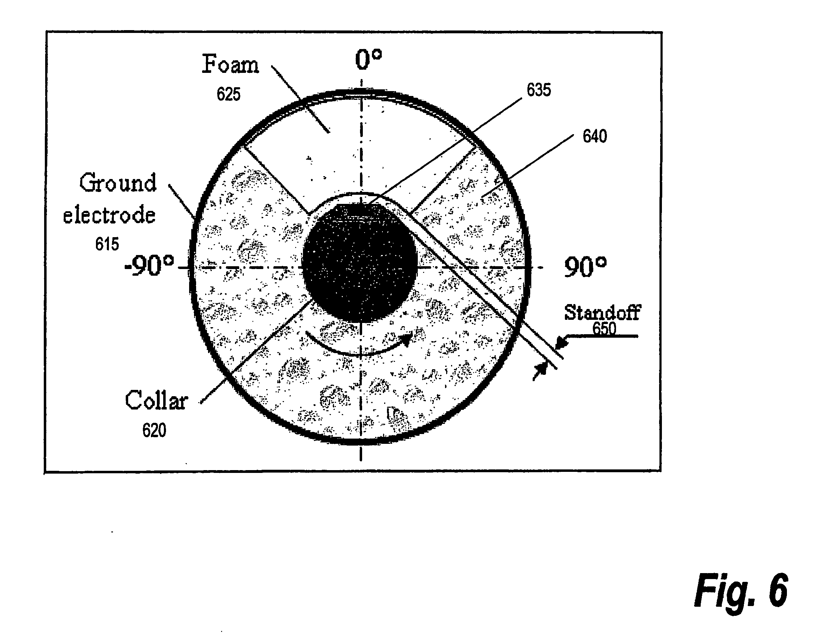

Figure 6 is a diagram showing another test setup for determining azimuthal button response and standoff response versus frequency in accordance with one embodiment.

Standoff 650 represents the distance between electrode 635 surface and the sidewall of the borehole (ground electrode 615). In one embodiment, to obtain accurate resistivity data, the standoff distance between the electrode surface and the sidewall is be kept as small as possible. A small standoff distance, however, makes the electrodes more vulnerable to damage caused by the sidewall of the borehole in a LWD drilling environment. To protect the electrodes from direct mechanical impact, the electrode surfaces may be slightly recessed below the surface of the tool collar/stabilizer/blade 620. Thus, the rate and degree of cleaning the electrode surface and tool collar/stabilizer blade surface will be different. This results in non-identical build up of impedance layers on electrode 635 surface and tool collar/stabilizer/blade 320. This, in turn, may lead to creation of leakage currents and noise artifacts in the resistivity response of the electrode. Noise artifacts may become pronounced while logging resistive beds, but are also visible in conductive beds, especially while crossing high-resistivity boundaries.

In one embodiment, conductive fluid 640 may be salt water with a resistivity of 0.1 ohm-meter. The inner wall of the barrel is covered with a steel sheet (ground electrode 615) to form a wide-area ground electrode. When AC voltage is applied between the tool collar and the ground electrode, current flows through the salt water laterally to the collar surface. The current flow pattern in the test setup of Figure 6 is similar to current flow that may be experienced in a resistivity tool of an actual borehole. A closed-cell foam sector 620 having a ninety-degree arc is placed between the tool collar section and the ground electrode as shown. The purpose of the closed-cell foam sector in front of the button electrode is to prevent lateral current flow between the button electrode in the tool collar and the ground electrode. Thus, any current received/transmitted by the electrode may be parasitic, caused by focusing inefficiency of the electrode-ground electrode system at any given standoff between the button electrode and the closed-cell foam sector.

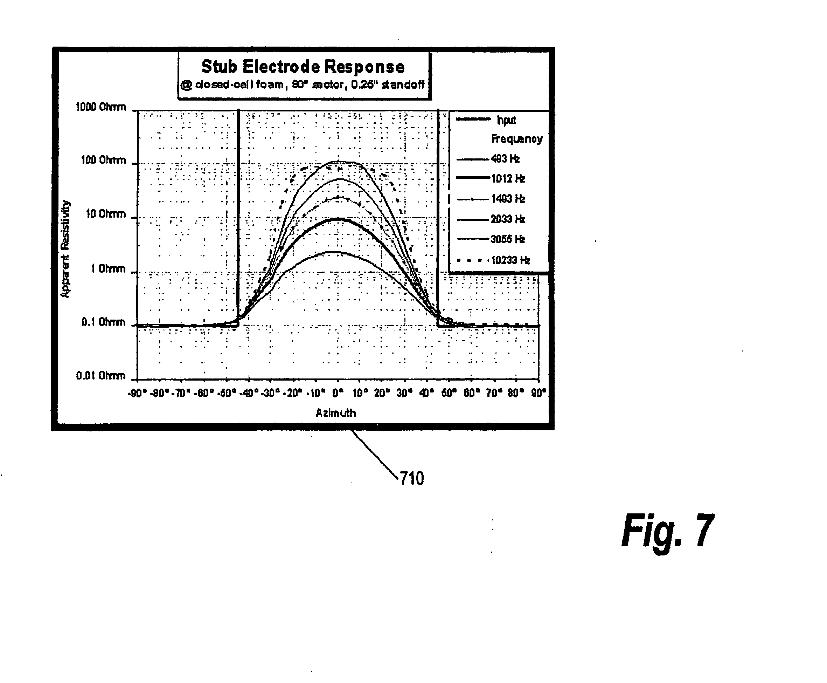

Figure 7 is a graph of resistivity versus azimuthal angle with data collected using the test setup shown Figure 6 over a number of frequencies with ¼" standoff in a 0.1 ohm-meter fluid in accordance with one embodiment. The results of the experiments performed indicate that the focusing of AC current is greater at higher frequencies, which supports the idea of enhancing imaging accuracy by operating at frequencies above 1 to 1.5 KHz.

Graph 710 of Figure 7 shows an ideal resistivity response (solid black vertical lines labeled Input). According to the ideal response, the resistivity response is infinite where the electrode faces the insulating foam. As is shown by the remaining curves at different frequencies, the electrode's resistivity response differs from the ideal response. However, as is shown in graph 710, with higher operating frequency, the electrode's resistivity response will more closely resemble the ideal response (see the response for a frequency of 10233 Hz). Thus, focusing of the AC current at higher frequency is better and consequently resistivity image quality would be better at higher frequency. In the test setup shown in Figure 6, the influence of skin depth, a measure of the effective depth of penetration of electromagnetic fields, may be neglected. Skin depth may be defined as the depth at which the amplitude of electromagnetic waves in the field drops to 37% of its surface value. Skin depth may be neglected as the radius of the test barrel is approximately 1 foot, while the skin depth in a 0.1 ohm-meter fluid at 10 KHz is greater than 5 feet

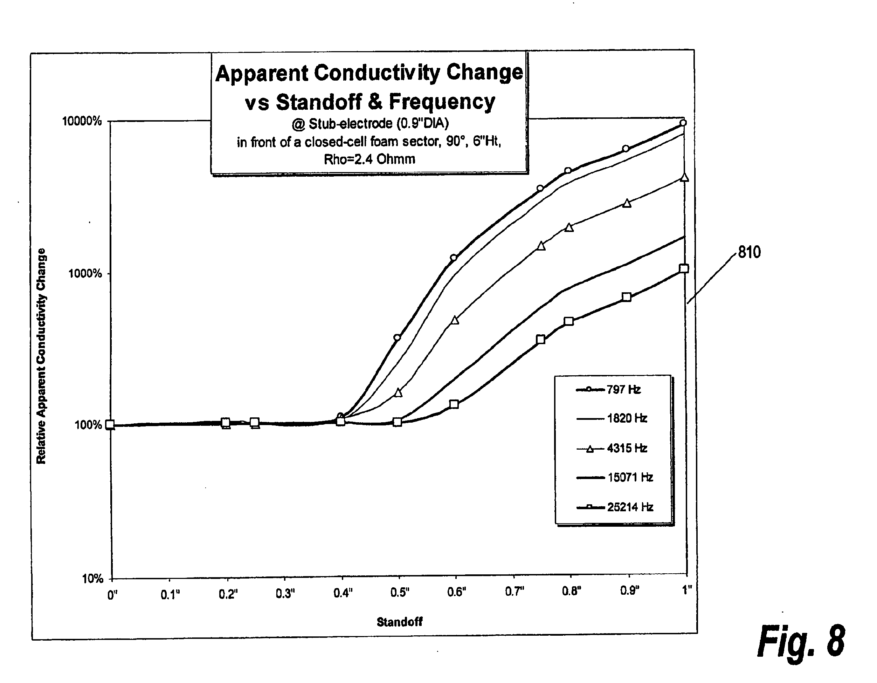

Figure 8 is a graph of conductivity change versus standoff with data collected using the test setup of Figure 6 over a number of frequencies in accordance with one embodiment Graph 810 shows how conductivity changes again changes in standoff distance over a range of frequencies. The data for this graph was collected by performing an experiment in which the electrode's azimuthal position was fixed in front of the center of the closed-cell foam sector and the standoff distance between the button electrode face and the foam sector was varied. Conductivity is defined as 1/resistivity and is measured in Siemens/meter or mho/meter. Conductivity measurements determined at zero standoff distance for each frequency were used as the base values to calculate the relative conductivity change at each standoff distance. As is shown in Figure 8, the relative conductivity change is insignificant for all frequencies until the standoff reaches 0.4 inch, a distance approximately equaling the electrode's radius. From this point, the relative conductivity begins to increase from the base value as the standoff distance. The curves at different frequencies indicate that with increasing standoff distance, the relative conductivity change appears to decrease with increasing frequency. Across all frequency curves, as the standoff distance increases, the electrode collects more and more current and thus the measurements become more and more inaccurate. As described above, in the ideal case, no current is expected to pass laterally through the insulating foam.

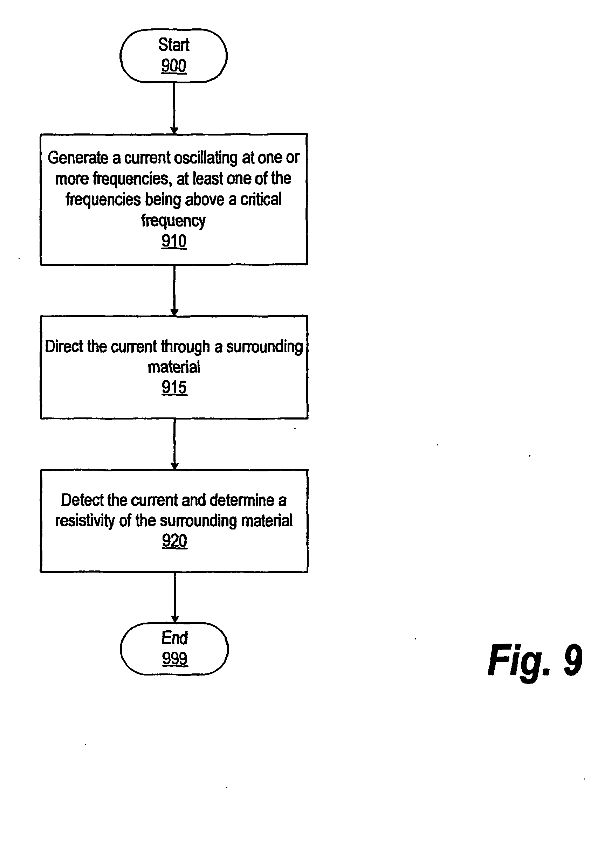

Figure 9 is a flow diagram describing a method for detecting current through a material to measure the resistivity of the material in accordance with one embodiment. The method begins at 900 whereupon, at step 910, a current oscillating at one or more frequencies is generated. At least one of the frequencies of the current is above a critical frequency. At step 915, the current is directed through a surrounding material, and at step 920, the current is detected and a resistivity of the surrounding material is determined at the one or more frequencies. The method ends at 999.

Resistivity tools operating over a wide range of frequencies may yield additional useful information. Because AC current of different frequencies attenuates at different rates in the same conductive medium, meaningful interpretation of a multifrequency resistivity response may be derived.

In some embodiments, the resistivity logging is performed in multifrequency mode at a frequency above 1 KHz. In some embodiments of the invention, the frequency of AC current during resistivity logging may be 50 KHz or higher. A more accurate formation resistivity data may be determined based on multifrequency electrode response extrapolation and parameters for calibration of the response data as described above. Formation resistivity data may be further refined by independent determination of standoff distance.

Electrode response over a range of frequencies may be used to estimate the quality of collected resistivity log data and accept or reject it when the relative difference between the electrode responses collected at different frequencies will match or exceed some predefined value. The response over a range of frequencies may also be used to gather resistivity data of the formation at different radii from the tool in order to create a lateral image of the earth formation.

While the invention has been disclosed with respect to a limited number of embodiments, those skilled in the art will appreciate numerous modifications and variations therefrom. It is intended that the following claims be interpreted to embrace all such variations and modifications. By way of example, it is recognized that the disclosed method and apparatus for improved focusing of current and compensation for standoff distance effect during formation resistivity measurements may be performed during wireline well logging. In wireline well logging, a logging device suspended from a wireline cable is lowered into the borehole after the drill string has been removed. The logging device makes measurements while the cable is withdrawn.

Those of skill will appreciate that the various illustrative logical blocks, modules, circuits, and algorithm steps described in connection with the embodiments disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Those of skill in the art may implement the described functionality in varying ways for each particular application, but such implementation decisions should not be interpreted as causing a departure from the scope of the present invention.

The benefits and advantages that may be provided by the present invention have been described above with regard to specific embodiments. These benefits and advantages, and any elements or limitations that may cause them to occur or to become more pronounced are not to be construed as critical, required, or essential features of any or all of the claims. As used herein, the terms "comprises," "comprising," or any other variations thereof, are intended to be interpreted as non-exclusively including the elements or limitations which follow those terms. Accordingly, a system, method, or other embodiment that comprises a set of elements is not limited to only those elements, and may include other elements not expressly listed or inherent to the claimed embodiment

While the present invention has been described with reference to particular embodiments, it should be understood that the embodiments are illustrative and that the scope of the invention is not limited to these embodiments. Many variations, modifications, additions and improvements to the embodiments described above are possible. It is contemplated that these variations, modifications, additions and improvements fall within the scope of the invention as detailed within the following claims.

## Claims

1. A method for resistivity logging, the method comprising:
generating a current, the current oscillating at a plurality of different frequencies;
directing the current into a surrounding material from a borehole containing a conductive fluid; and
detecting the current via electrodes (115) and, in response thereto, determining a resistivity of the surrounding material at different frequencies, which resistivity is collected as resistivity log data; and
accepting or rejecting the collected resistivity log data when a relative difference between electrode responses at different frequencies matches or exceeds a predefined value.

2. The method of Claim 1, wherein at least one of the plurality of different frequencies is above a critical frequency, and the resistivity as determined at frequencies higher than the critical frequency is substantiaily equal to the resistivity at the critical frequency.

3. The method of Claim 2, wherein the critical frequency is equal to approximately 1 kHz.

4. The method of Claim 1, wherein the detecting the current comprises detecting one or more current characteristics, wherein the one or more current characteristics are chosen from the group consisting of: amplitude and phase.

5. The method of Claim 1, wherein directing the current comprises directing the current using one or more button or ring electrodes.

6. The method of Claim 1, wherein generating the current comprises employing multiple voltage generators to output AC voltages each at a different frequency.

7. An apparatus for resistivity logging, the apparatus comprising:
a current generating device, the device being operable to generate a current oscillating at a plurality of different frequencies;
one or more electrodes (115) coupled to the generating device, the electrodes being adapted to direct current from a conductive-fluid-filled borehole into a surrounding material; and
an analysis device coupled to the one or more electrodes, the analysis device being operable to detect the current and, in response thereto, determine a resistivity of the surrounding material at different frequencies, which resistivity is collected as resistivity log data, and the analysis device being further operable to accept or reject collected resistivity log data when a relative difference between electrode responses at different frequencies matches or exceeds a predefined value.

8. The apparatus of Claim 7, wherein the electrodes are button electrodes or ring electrodes.

9. The apparatus of Claim 7, wherein at least one of the plurality of different frequencies is above a critical frequency, and the resistivity as determined at frequencies higher than the critical frequency is substantially equal to the resistivity at the critical frequency..

10. The apparatus of Claim 9, wherein the critical frequency is equal to approximately 1 kHz.

11. The apparatus of Claim 7, wherein the analysis device is further operable to detect one or more current characteristics, wherein the one or more current characteristics are chosen from the group consisting of: amplitude and phase.

12. The apparatus of Claim 7, wherein the current generating device employs multiple voltage generators to output AC voltages each at a different frequency.

13. The apparatus of Claim 7, wherein the current generating device and the analysis device comprise components chosen from the group consisting of: resistors, operational amplifiers, and transformers.

## Patentansprüche

1. Verfahren zum Aufzeichnen von Resistivität, wobei das Verfahren Folgendes beinhaltet:
Erzeugen eines Stroms, wobei der Strom mit mehreren verschiedenen Frequenzen oszilliert;
Leiten des Stroms in ein umgebendes Material von einem Bohrloch, das ein leitendes Fluid enthält; und
Erfassen des Stroms über Elektroden (115) und Ermitteln, als Reaktion darauf, einer Resistivität des umgebenden Materials bei unterschiedlichen Frequenzen, wobei die Resistivität als Resistivitätsprotokolldaten gesammelt wird; und
Akzeptieren oder Zurückweisen der gesammelten Resistivitätsprotokolldaten, wenn eine relative Differenz zwischen Elektrodenreaktionen bei unterschiedlichen Frequenzen mit einem vordefinierten Wert übereinstimmt oder ihn übersteigt.

2. Verfahren nach Anspruch 1, wobei wenigstens eine der mehreren verschiedenen Frequenzen über einer kritischen Frequenz liegt und die Resistivität, die bei Frequenzen über der kritischen Frequenz ermittelt wird, im Wesentlichen gleich der Resistivität bei der kritischen Frequenz ist.

3. Verfahren nach Anspruch 2, wobei die kritische Frequenz etwa 1 kHz beträgt.

4. Verfahren nach Anspruch 1, wobei das Erfassen des Stroms das Erfassen von einem oder mehreren Stromkennwerten beinhaltet, wobei die ein oder mehreren Stromkennwerte aus der Gruppe bestehend aus Amplitude und Phase ausgewählt sind.

5. Verfahren nach Anspruch 1, wobei das Leiten des Stroms das Leiten des Stroms mit einer oder mehreren Knopf- oder Ringelektroden beinhaltet.

6. Verfahren nach Anspruch 1, wobei das Erzeugen des Stroms das Anwenden von mehreren Spannungsgeneratoren zum Ausgeben von Wechselspannungen jeweils mit einer anderen Frequenz beinhaltet.

7. Vorrichtung zum Aufzeichnen von Resistivität, wobei die Vorrichtung Folgendes umfasst:
eine Stromerzeugungsvorrichtung, wobei die Vorrichtung die Aufgabe hat, einen Strom zu erzeugen, der mit mehreren verschiedenen Frequenzen oszilliert;
eine oder mehrere mit der Erzeugungsvorrichtung gekoppelte Elektroden (115), wobei die Elektroden zum Leiten von Strom von einem mit einem leitenden Fluid gefüllten Bohrloch in ein umgebendes Material ausgelegt ist; und
eine Analysevorrichtung, die mit den ein oder mehreren Elektroden gekoppelt ist, wobei die Analysevorrichtung die Aufgabe hat, den Strom zu erfassen und als Reaktion darauf eine Resistivität des umgebenden Materials bei unterschiedlichen Frequenzen zu ermitteln, wobei die Resistivität als Resistivitätsprotokolldaten gesammelt wird, und wobei die Analysevorrichtung ferner die Aufgabe hat, gesammelte Resistivitätsprotokolldaten zu akzeptieren oder zurückzuweisen, wenn eine relative Differenz zwischen Elektrodenreaktionen bei unterschiedlichen Frequenzen mit einem vordefinierten Wert übereinstimmt oder ihn übersteigt.

8. Vorrichtung nach Anspruch 7, wobei die Elektroden Knopfelektroden oder Ringelektroden sind.

9. Vorrichtung nach Anspruch 7, wobei wenigstens eine der mehreren verschiedenen Frequenzen über einer kritischen Frequenz liegt und die Resistivität, die bei Frequenzen über der kritischen Frequenz ermittelt wird, im Wesentlichen gleich der Resistivität bei der kritischen Frequenz ist.

10. Vorrichtung nach Anspruch 9, wobei die kritische Frequenz etwa 1 kHz beträgt.

11. Vorrichtung nach Anspruch 7, wobei die Analysevorrichtung ferner die Aufgabe hat, einen oder mehrere Stromkennwerte zu erfassen, wobei die ein oder mehreren Stromkennwerte aus der Gruppe bestehend aus Amplitude und Phase ausgewählt sind.

12. Vorrichtung nach Anspruch 7, wobei die Stromerzeugungsvorrichtung mehrere Spannungsgeneratoren zum Ausgeben von Wechselspannungen jeweils mit einer anderen Frequenz verwendet.

13. Vorrichtung nach Anspruch 7, wobei die Stromerzeugungsvorrichtung und die Analysevorrichtung Komponenten umfassen, die aus der Gruppe bestehend aus Widerständen, Operationsverstärkern und Transformatoren ausgewählt sind.

## Revendications

1. Procédé pour effectuer une diagraphie de résistivité, ce procédé comprenant :
la génération d'un courant, ce courant oscillant à une pluralité de fréquences différentes ;
l'orientation de ce courant dans un matériau environnant depuis un trou de forage contenant un fluide conducteur ; et
la détection de ce courant via des électrodes (115) et, en réponse à celui-ci, la détermination d'une résistivité de la matière environnante à différentes fréquences, laquelle résistivité est recueillie comme des données de diagraphie de résistivité ; et
l'acceptation ou le rejet des données de diagraphie de résistivité recueillies lorsqu'une différence relative entre les réponses des électrodes à différentes fréquences correspond à une valeur prédéfinie ou la dépasse.

2. Procédé selon la revendication 1, dans lequel au moins une de la pluralité de différentes fréquences est au-dessus d'une fréquence critique, et la résistivité telle que déterminée à des fréquences plus hautes que la fréquence critique est essentiellement égale à la résistivité à la fréquence critique.

3. Procédé selon la revendication 2, dans lequel la fréquence critique est égale à environ 1 kHz.

4. Procédé selon la revendication 1, dans lequel la détection du courant comprend la détection d'une ou de plusieurs caractéristiques du courant, cette ou ces caractéristiques du courant étant choisies parmi le groupe comprenant : l'amplitude et la phase.

5. Procédé selon la revendication 1, dans lequel l'orientation du courant comprend l'orientation du courant en utilisant une ou plusieurs électrodes-boutons ou électrodes annulaires.

6. Procédé selon la revendication 1, dans lequel la génération du courant comprend l'utilisation de générateurs de tension multiples pour fournir des tensions alternatives chacune à une fréquence différente.

7. Appareil pour effectuer une diagraphie de résistivité, cet appareil comprenant :
un dispositif générateur de courant, ce dispositif pouvant être utilisé de façon à générer un courant oscillant à une pluralité de fréquences différentes ;
une ou plusieurs électrodes (115) couplées au dispositif de génération, ces électrodes étant adaptées de façon à diriger du courant depuis un puits de forage rempli de fluide conducteur dans une matière environnante ; et
un dispositif d'analyse couplé à l'électrode ou aux électrodes, ce dispositif d'analyse pouvant être utilisé de façon à détecter le courant et, en réponse à celui-ci, à déterminer une résistivité de la matière environnante à différentes fréquences, laquelle résistivité est recueillie comme des données de diagraphie de résistivité, et ce dispositif d'analyse pouvant être utilisé en outre de façon à accepter ou à rejeter les données de diagraphie de résistivité recueillies lorsqu'une différence relative entre les réponses des électrodes à différentes fréquences correspond à une valeur prédéfinie ou la dépasse.

8. Appareil selon la revendication 7, dans lequel les électrodes sont électrodes boutons ou des électrodes annulaires.

9. Procédé selon la revendication 7, dans lequel au moins une de la pluralité de différentes fréquences est au-dessus d'une fréquence critique, et la résistivité telle que déterminée à des fréquences plus hautes que la fréquence critique est essentiellement égale à la résistivité à la fréquence critique.

10. Appareil selon la revendication 9, dans lequel la fréquence critique est égale à environ 1 kHz.

11. Appareil selon la revendication 7, dans lequel le dispositif d'analyse peut être utilisé en outre de façon à détecter une ou plusieurs caractéristiques du courant, cette ou ces caractéristiques du courant étant choisies parmi le groupe comprenant : l'amplitude et la phase.

12. Appareil selon la revendication 7, dans lequel le dispositif de génération de courant utilise des générateurs de tension multiples pour fournir des tensions alternatives chacune à une fréquence différente.

13. Appareil selon la revendication 7, dans lequel le dispositif de génération de courant et le dispositif d'analyse comprennent des composants choisis parmi le groupe comprenant des résistances, des amplificateurs opérationnels et des transformateurs.
